(19) Europäisches Patentamt

European Patent Office

Office européen des brevets

(11) Publication number: **0 445 759 A1**

(12) **EUROPEAN PATENT APPLICATION**

(21) Application number: 91103382.7

(22) Date of filing: 06.03.91

(51) Int. Cl.⁵: **H01L 23/538**

(30) Priority: 07.03.90 JP 55547/90

(43) Date of publication of application:
**11.09.91 Bulletin 91/37**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Sugawara, Noritoshi, c/o Fujitsu**
**Limited**
**Patent Department, 1015 Kamikodanaka**
**Nakahara-ku, Kawasaki-shi, Kanagawa**
**211(JP)**
Inventor: **Satoh, Kazuaki, c/o Fujitsu Limited**
**Patent Department, 1015 Kamikodanaka**
**Nakahara-ku, Kawasaki-shi, Kanagawa**
**211(JP)**

(74) Representative: **Sunderland, James Harry et al**
**HASELTINE LAKE & CO Hazlitt House 28**
**Southampton Buildings Chancery Lane**
**London WC2A 1AT(GB)**

(54) Multilayer structures with layer interconnection.

�ហ A multilayer structure with
a first electrically conductive pattern (2);
an insulative layer (4) formed over the first electrically conductive pattern (2);
a second electrically conductive pattern (3) formed on said insulative layer (4); and
an electrically conductive pin (5) piercing the insulative layer (4) so as to connect said first (2) and second (3) electrically conductive layers, an end (5A) of said pin (5) being cold-welded to said first electrically conductive pattern (2), another end (5B) of said pin (5) contacting said second electrically conductive pattern (3).
A method of fabricating such a structure, in which the insulative layer (4) may be of organic resin which is hardened after piercing by the pin (5).

FIG.2

The present invention relates to multilayer structures, for example as employed in hybrid IC's (integrated circuits) or semiconductor devices, etc. More particularly, it is related to connection of different electrically conductive layers in the structure, insulated by an insulative layer therebetween.

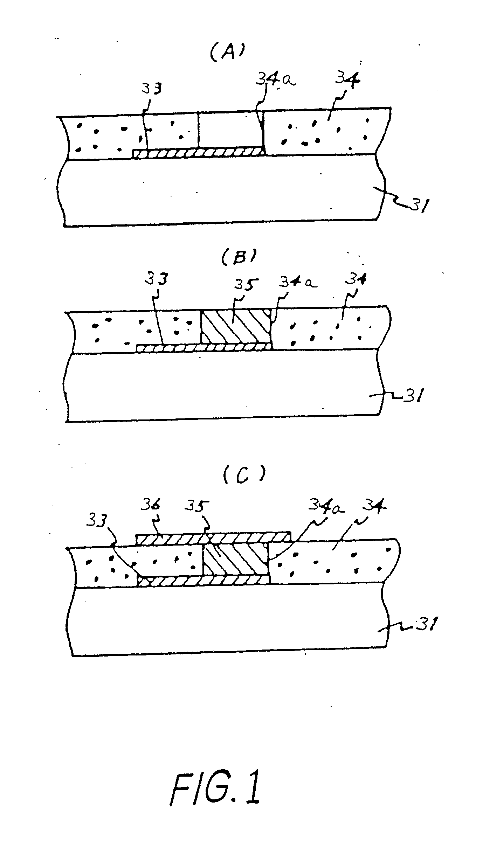

Many kinds of multilayer structures have been employed and many methods for fabricating such structures in hybrid IC's (integrated circuit) or semiconductor devices have been used. A typical example is found in Japanese Unexamined Patent Publication Sho-61-22693 and illustrated in Fig. 1. In this method, an insulative layer 34 is coated over an electrically conductive pattern 33 formed on an insulative substrate 31. A via hole 34a is opened on a predetermined position of insulative layer 34 as shown in step (A) of Fig. 1. Via hole 34a is then filled with a metal material by either electroplating or electroless plating so that a via 35 is formed therein as shown in step (B). A second electrically conductive pattern 36 is formed over thus fabricated insulative layer 34, as shown in step (C).

This method, however, suffers problems as described hereinafter. That is, it requires a very long time, for example more than 24 hours, for forming a 20 $\mu$m thick via in the via hole by electroless plating. The required time can be reduced by employing electroplating. However, not only is the via top uneven with the surface of insulative layer 34 but a mechanical stress also occurs at the connection of the second pattern 36 and the peripheral part of via 35 after the second pattern 36 is formed, resulting in the possibility of disconnection being caused. This is because a photosensitive polyimide resin employed for insulative layer 34 has a thermal expansion coefficient widely different from that of the metal material of via 35. Another problem is suffered in that the via does not adequately adhere to the insulative layer. As a result of these problems, reliability of connection between multilayers has not been satisfactory.

In order to avoid the problem of mismatched thermal expansion coefficients, the employment of a non-photosensitive polyimide resin can be considered. However, this is disadvantageous in that such a material requires the use of a metal mask or a resist which is resistant to plasma, which requires a complicated fabrication process, resulting in deterioration of process reliability.

Embodiments of the present invention can provide multilayer structures, and fabrication methods therefor, in which two electrically conductive layers insulated by a resin layer therebetween are reliably connected.

Embodiments of the present invention can provide multilayer structures and fabrication methods therefor in which improved flatness of each layer allows for a greater number of multiple layers.

In accordance with an embodiment of the present invention, a multilayer structure is fabricated by forming a first electrically conductive pattern on a substrate; coating an insulative resin layer all over the first electrically conductive pattern; piercing a metal pin into the resin layer so that a first end of the pin contacts and is cold-welded to the first electrically conductive pattern; hardening the insulative resin layer; and forming a second electrically conductive pattern over the resin layer and over the second end of the pin exposed from the surface of the resin layer.

Reference is made, by way of example, to the accompanying drawings, in which:-

Fig. 1 schematically illustrates fabrication steps in the production of a prior art multilayer structure;

Fig. 2 is a schematic cross-sectional view illustrating a multilayer structure in accordance with an embodiment of the present invention; and

Fig. 3 gives schematic cross-sectional views illustrating fabrication steps in the production of the electrically conductive layer structure of Fig. 2 in accordance with an embodiment of the present invention.

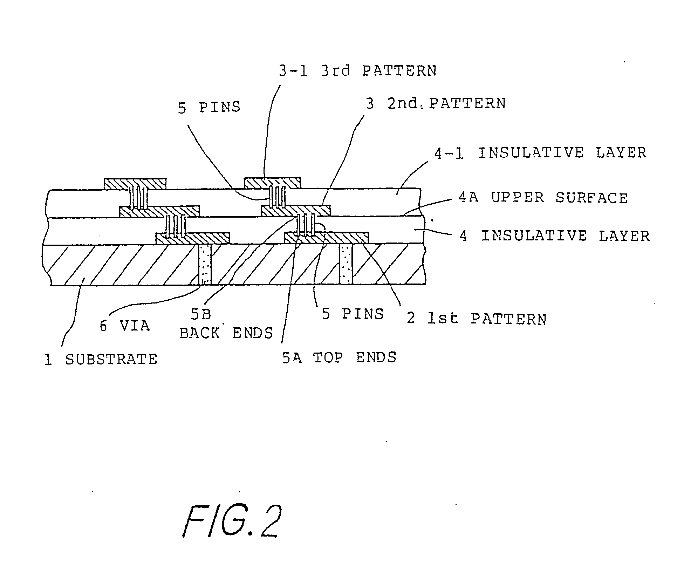

As shown in Fig. 2, a first electrically conductive pattern 2 deposited upon an e.g. insulative substrate 1 formed of, for example, ceramic is connected to a second electrically conductive pattern 3 deposited upon a first insulative layer 4 coated all over first pattern 2 and substrate 1, by pins 5 which pierce insulative layer 4 made of resin. Furthermore, a second insulative layer 4-1 is coated all over the surface 4A of first insulative layer and second pattern 3. Upon second insulative layer 4-1, a third electrically conductive pattern 3-1 is deposited, from which pins 5' pierce second insulative layer 4-1 so as to connect to second pattern 3. Thus, first, second and third patterns 2, 3 and 3-1 are connected with each other. Substrate 1 also has vias 6 such as to communicate with first pattern 2 from the bottom side of substrate 1.

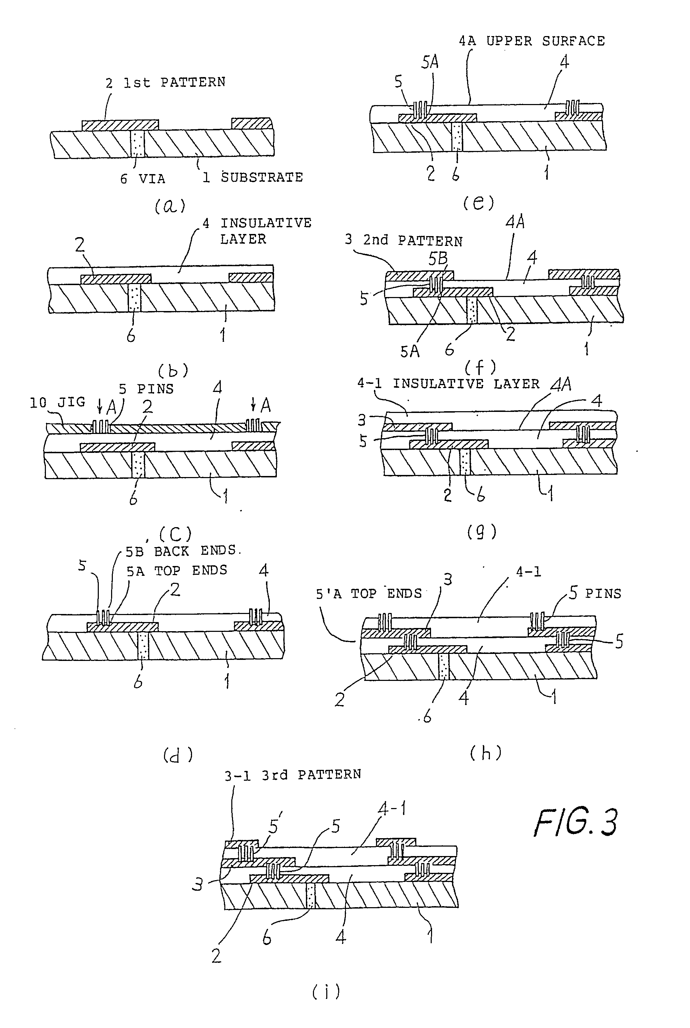

Steps for fabrication of the Fig. 2 multilayer structure are explained hereinafter with reference to Fig. 3.

Substrate 1, for example formed of ceramic, is provided in advance with vias 6. A wiring pattern 2 is fabricated using a relatively soft electrically conductive material, such as aluminium or copper, as thick as 7 $\mu$m upon a predetermined portion of substrate 1, as shown in step (a) in Fig. 3.

Polyamic acid resin, which is a material to become non-photosensitive polyimide resin, or for some cases a solution of polyimide, is coated flatly all over substrate 1 having first pattern 2 thereon, to a thickness of for instance 10 to 20 $\mu$m, so as to

form first insulative layer 4, as shown in step (b) of Fig. 3.

On the other hand, a plurality of whiskers of for example 5 to 10 $\mu$m diameter, and 30 ± 1 $\mu$m long, for example of molybdenum or tungsten, for instance plated with chrome, are prepared. A jig 10 made with an approximately 20 $\mu$m thick stainless sheet having holes of approximately 80 $\mu$m diameter is placed on insulative layer 4. The holes are located at the places where the pins 5 are to be provided for connecting first and second patterns 2 and 3. Then, an appropriate number of pins 5 for example 5 or 6, are inserted into each of the holes by the use of an appropriate tool, which is not shown in the Figure, as shown in step (c) of Fig. 3.

Back ends 5B of pins 5 (uppermost in Fig. 3) are pressed down in the direction of arrow A into the resin layer 4 by a tool, which is not shown in the Figure, so that the pins 5 pierce polyimide resin layer 4 to reach first pattern 2. The polyamic acid resin is so soft as to allow the pins made of hard metal whiskers to easily pierce the resin layer and to adhere therewith. Furthermore, the pointed ends 5A or tips of the pins press the first pattern 2 so as to be cold-welded therewith. The chrome plated over the pins also reacts with the polyamic acid resin. Due to these facts, good adhesion is achieved between the resin and the pins. Back ends 5B of pins 5 are then protruding from the top surface level of insulative layer 4 to some degree, such as 3 to 5 $\mu$m. Next, the substrate from which jig 10 has been removed and having the resin layer thereon is heated at 350 to 450°C for 30 to 60 minutes so that the resin is hardened to become polyimide (step d of Fig. 3).

Next, back ends 5B of pins 5 are mechanically ground to a level height, if needed. Usually, this process, shown as step (e) in Fig. 3, will not be necessary, because this process is required only when the back ends 5B are excessively unequal or too high from the upper surface 4A of insulative layer 4.

Next, an electrically conductive soft metal, such as copper, is formed over insulative layer 4 by an electroplating technique and patterned using a photolithography technique so as to form second pattern 3. Back ends 5B of pins 5 are surely connected with the plated material, i.e. second pattern 3, by this plating process, because the protruding back ends 5B present a relatively extensive area to be plated. This plating is carried to a thickness, for example, of approximately 7 $\mu$m on flat portions. However, deposition by the plating can be reduced particularly on the 3 to 5 $\mu$m protruding back ends 5B according to a widely known levelling effect occurring with the plating technique. Therefore, surface of second pattern 3 can be finished with adequate flatness over pins 5.

Thus, the first and second patterns 2 and 3 are connected to each other by pins 5 (step f of Fig. 3).

Next, non-photosensitive polyimide resin is coated all over first insulative layer 4 having second pattern 3 thereon in the same way as described for step b of Fig. 3, in order to form second insulative layer 4-1, as shown in step g of Fig. 3.

Next, another bunch of pins 5' is pressed into polyimide resin layer 4-1, and further pressed into second pattern 3 by the same method as described in steps c to d or steps c to e of Fig. 3 (step h of Fig. 3).

Next, a third electrically conductive pattern 3-1 is formed over second insulative layer 4-1 and over back ends 5'A of pins 5' by the same method as used in relation to the first and second patterns. As described above for second pattern 3, third pattern 3-1 can be made adequately flat even over back ends 5'B of pins 5', as shown in step i of Fig. 3.

Therefore, the problems frequently occurring in the prior art structure, such as disconnection of wiring due to steep level differences caused by layers and vias, in fabricating second insulative layer 3 and third pattern 3-1 thereon, can be solved. Consequently, a multilayer structure having a greater number of layers than is possible in the prior art can be achieved without deterioration in the reliability of the connection of the multilayers.

In structure and fabrication processes, in accordance with embodiments of the present invention, non-photosensitive polyimide resin can be employed for insulative layers (4 and 4-1) instead of photosensitive polyimide resin. Non-photosensitive polyimide resins are available with a much wider range of thermal expansion coefficients than photosensitive polyimide resins. Accordingly, non-photosensitive polyimide resin which satisfactorily matches the thermal expansion coefficient of the pins can be easily selected for the insulative layers. Moreover, since the pins are in contact with the resin before the hardening of the resin good adhesion is achieved between pins and resin. Therefore, heat cycles during the field operation of the multilayer devices causes no mechanical stress at the connection point of the pins and the first and second patterns. Furthermore, the pins are cold-welded to the first pattern, as well as having sufficient area to be reliably plated with the second pattern. As a result of these facts, causes of breakages in connections between pins and patterns are removed, so that the reliability of the multilayer devices is excellent.

Moreover, in accordance with embodiments of the present invention, processes for opening via holes in an insulative layer, for connecting a lower pattern and an upper pattern, are not necessary. Accordingly, the steps of photolithography and a subsequent etching process are not necessary, resulting in a simplification of fabrication procedures.

Though in the above description the quantity of pins used for single connection is referred to as 5 or 6 as a single via, the pin quantity can be arbitrarily chosen depending on requirements. Signal propagation characteristics of the connection can be adjusted by the quantity of the pins.

Though, in Figs. 2 and 3, substrate 1 is shown to have via holes 6 therein, it will be apparent that embodiments of the present invention can be employed with substrates having no vias therein.

A multilayer structure in accordance with an embodiment of the invention is fabricated by patterning a first electrically conductive layer on an insulative substrate; coating a polyamic acid resin layer all over the first electrically conductive layer; piercing a metal pin into the resin layer so that a first end of the pin contacts and is cold-welded to the first electrically conductive layer; hardening said polyamic acid resin to become polyimide resin; and patterning a second electrically conductive layer over the resin layer and the second end of the pin exposed from the surface of the resin layer. The cold-welding of the pin to the first conductive layer allows a reliable connection thereof. Moreover, this structure and method allow improved flatness for each layer, resulting in the ability to achieve a greater number of multilayers without the prior art problem of broken patterns caused by less flat layers. Since polyimide resin which does not need to be photosensitive can used, a resin can be chosen so that its thermal expansion coefficient can closely match that of the pin. Accordingly, no thermal stress is generated at the connection between the pin and the second conductive layer, resulting in an improved reliability of the connection.

## Claims

1. A multilayer structure comprising:
   a first electrically conductive pattern (2);
   an insulative layer (4) formed over the first electrically conductive pattern (2);
   a second electrically conductive pattern (3) formed on said insulative layer (4);
   and characterised by
   an electrically conductive pin (5) piercing the insulative layer (4) so as to connect said first (2) and second (3) electrically conductive layers, an end (5A) of said pin (5) being cold-welded to said first electrically conductive pattern (2), another end (5B) of said pin (5) contacting said second electrically conductive pattern (3).

2. A multilayer structure as claimed in claim 1, wherein a plurality of such pins (5) are provided.

3. A multilayer structure as claimed in claim 2, wherein the pins (5) of the plurality are grouped together.

4. A multilayer structure as claimed in claim 1, 2 or 3, wherein the or each pin is of molybdenum or tungsten.

5. A multilayer structure as claimed in claim 1, 2, 3 or 4, wherein the or each pin (5) is plated with chrome.

6. A multilayer structure as claimed in claim 1, 2, 3, 4 or 5, wherein said insulative layer (4) is formed of an organic (plastic) resin.

7. A multilayer structure as claimed in claim 6, wherein said insulative layer (4) is formed of a non-photosensitive material.

8. A multilayer structure as claimed in claim 7, wherein said non-photosensitive material is polyimide.

9. A multilayer structure as claimed in any preceding claim, wherein said insulative layer (4) has a thermal expansion coefficient which is approximately equal to the thermal expansion coefficient of the or each pin (5).

10. A method of fabricating a multilayer structure, comprising the steps of:
    forming a first electrically conductive pattern (2);
    coating an insulative layer (4) over the first electrically conductive pattern (2);
    forming a second electrically conductive pattern (3) over said insulative layer (4); and
    providing an electrically conductive connection (5) between the first (2) and second (3) electrically conductive patterns, through the insulative layer (4);
    characterised in that
    said electrically conductive connection (5) is provided by piercing an electrically conductive pin (5) into said insulative layer (4) so that a first end (5A) of said pin (5) contacts said first electrically conductive pattern (2) by being cold-welded thereto; said second electrically conductive pattern (3) being formed over a second end (5B) of said pin (5).

11. A method as claimed in claim 10, in which said insulative layer (4) is an organic resin layer and the organic resin is hardened after piercing by the pin (5).

12. A method as claimed in claim 10 or 11, wherein a plurality of such pins (5) are provided.

13. A method as claimed in claim 12, wherein the pins of the plurality are grouped together.

14. A method as claimed in claim 10, 11, 12 or 13, wherein the or each pin (5) is of molybdenum or tungsten.

15. A method as claimed in claim 10, 11, 12, 13 or 14, wherein the or each pin (5) is plated with chrome.

16. A method as claimed in any one of claims 10 to 15, wherein the forming of said second electrically conductive pattern (3) is carried out by electroplating.

17. A method as claimed in any one of claims 10 to 16, further comprising the step of grinding said second end (5B) of the or each pin (5) before forming said second electrically conductive pattern (3).

18. A method as claimed in any one of claims 10 to 17, wherein said insulative layer (4) is formed of a non-photosensitive material.

19. A method as claimed in claim 18, wherein said non-photosensitive material is polyimide.

20. A method as claimed in claim 19, wherein said non-photosensitive material is a polyamic acid resin.

21. A method as claimed in any one of claims 10 to 20, wherein said insulative layer (4) has a thermal expansion coefficient which is approximately equal to the thermal expansion coefficient of the or each pin (5).

22. A method as claimed in any preceding claim, wherein said step of forming an insulative layer and the subsequent steps are further repeated.

(A)

(B)

(C)

FIG.1

3-1 3rd PATTERN

5 PINS

3 2nd PATTERN

4-1 INSULATIVE LAYER

4A UPPER SURFACE

4 INSULATIVE LAYER

6 VIA

5B BACK ENDS

5 PINS

2 1st PATTERN

1 SUBSTRATE

5A TOP ENDS

# FIG.2

FIG.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | WO-A-8 502 751 (LASERPATH) <br> * Figures 7,8; page 12, lines 5-37 * <br> – – – | 1,2,6,7, 10,12,18 | H 01 L 23/538 |
| A | RESEARCH DISCLOSURE, no. 309, January 1990, page 44, abstract no. 30964; "Dentrite connectors for low temperature system packaging" <br> – – – | | |
| P,A | FR-A-2 649 829 (NEC) <br> * Abstract; figures 2-4 * <br> – – – | 2,3,12,13, 22 | |
| A | WO-A-8 809 599 (CRAY) <br> * Figures 1,4,5,4a,5a,10; abstract * <br> – – – | 1,2,10,12, 22 | |
| A | EP-A-0 040 905 (FUJITSU) <br> – – – | | |
| A | FR-A-1 483 563 (IBM) <br> – – – | | |
| A | FR-A-2 468 279 (EDITIONS EDMOND DUJARDIN) <br> * Figures 1,2; page 2, lines 9-14 * <br> – – – – – | 2,3,6,7, 12,13,18 | |

TECHNICAL FIELDS SEARCHED (Int. Cl.5)

H 01 L

The present search report has been drawn up for all claims

| Place of search | Date of completion of search | Examiner |
|---|---|---|
| The Hague | 13 June 91 | PROHASKA G.A.F. |

CATEGORY OF CITED DOCUMENTS
X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons
............................................................
& : member of the same patent family, corresponding document